# EUROPEAN PATENT APPLICATION

(11) **EP 4 001 996 A2**
(43) Date of publication of application: **25.05.2022**
(21) Application number: 21205395.3
(22) Date of filing: 28.10.2021
(51) Int. Cl.: G02B 27/01, G02B 27/09, G02B 27/10, G02B 26/08, G02B 26/10, H04N 9/31, G02B 27/14

(54) **COMPACT OPTICAL MODULE**

(30) Priority: 29.10.2020 US 202017083548; 25.10.2021 US 202117509823
(71) Applicant: STMicroelectronics Ltd, 4250407 Netanya (IL)
(72) Inventor: DOMNITS, Alex, 7047220 Gedera (IL); ERLICH, Shlomy, 3088900 Caesarea (IL)
(74) Representative: Cerbaro, Elena

(57) **Abstract**

A compact optical package (10) includes an RGB laser unit (12) containing red, green, and blue laser diodes ((12a-12c)) within a single package, with three lenses (14a-14c) adjacent the RGB laser unit to collimate red, green, and blue laser light emitted by the red, green, and blue laser diodes. A beam combiner (16) combines the red, green, and blue laser light into a single RGB laser beam (33) and also outputs a lower power feedback beam. The optical package also includes a movable mirror apparatus (20, 24), and a fixed folding mirror (22) upon which the single RGB laser beam output by the beam splitter impinges and reflects the single RGB laser beam toward the movable mirror apparatus (20, 24). The movable mirror apparatus (20, 24) directs the single RGB laser beam (33) through an exit window (24) and to scan the single RGB laser beam in a scan pattern to form at least one desired image on a target.

## Description

This invention is directed to the field of laser scanning projectors and, in particular, to a compact optical module for use in laser scanning projectors.

A laser scanning projector or "picoprojector" is a small, portable electronic device. Picoprojectors are typically paired to, or incorporated within, user devices such as smart glasses, smartphones, tablets, laptops, or digital cameras, and used to project virtual and augmented reality, documents, images, or video stored on those user devices onto a projection surface, such as a wall, light field, holographic surface, or inner display surface of virtual or augmented reality glasses.

Such picoprojectors typically include a projection subsystem and an optical module. The paired user device serves an image stream (e.g., a video stream) to the projection subsystem. The projection subsystem properly drives the optical module so as to project the image stream onto the projection surface for viewing.

In greater detail, typical optical modules are comprised of a laser source and one or more microelectromechanical (MEMS) mirrors to scan the laser beam produced by the laser source across the projection surface in a projection pattern. By modulating the laser beam according to its position on the projection surface, while the laser beam is scanned in the projection pattern, the image stream is displayed. Commonly, at least one lens focuses the beam after reflection by the one or more MEMS mirrors, and before the laser beam strikes the projection surface, although optical modules of other designs may be used.

The projection subsystem controls the driving of the laser source and the driving of the movement of the one or more MEMS mirrors. Typically, the driving of movement of one of MEMS mirrors is at, or close to, the resonance frequency of that MEMS mirror, and the driving of movement of another of the MEMS mirrors is performed linearly and not at resonance.

While existing picroprojector systems are usable within virtual reality headsets and augmented reality glasses, due to the fact such devices are carried by the user's head, it is desired for such devices to be as light as possible. Additionally, particularly in the case of augmented reality glasses, it is also desired for such devices to be as compact as possible, since a pair of augmented reality glasses that externally appears no different than a common pair of eyeglasses would be highly commercially desirable. Current optical modules are larger and heavier than desired for virtual reality and augmented reality applications, and as such, further development into ways to shrink and lighten such optical modules is necessary.

Thus, an aim of the invention is to provide a solution to prior art limitations.

According to the invention, an optical package and an augmented reality package are provided, according to the attached claims.

Disclosed herein is an optical package, including a laser unit containing one or more laser diodes within a single package, one or more lenses adjacent the laser unit and configured to collimate laser light emitted by the one or more laser diodes of the laser unit, a beam combiner configured to combine the laser light from the one or more laser diodes into a single laser beam and to also output a lower power feedback beam, a movable mirror apparatus, and a fixed folding mirror upon which the single laser beam output by the beam combiner impinges and which is configured to reflect the single laser beam toward the movable mirror apparatus. The movable mirror apparatus is configured to direct the single laser beam through an exit window and to scan the single laser beam in a scan pattern to form at least one desired image on a target adjacent the optical package.

In some instances, the laser unit contains red, green, and blue laser diodes within a single package that lases to generate red, green, and blue laser light that is initially shone through a prism within the laser unit and which exit the prism to impinge upon the one or more lenses. In these instances, the one or more lenses are first, second, and third lenses upon which the red, green, and blue lasers impinge, and the single laser beam is a RGB laser beam.

The red, green, and blue laser diodes may each be formed within respective dies contained within the single package of the laser unit, and the respective die into which the red, green, and blue laser diodes may be formed are separated from one another by free space within the laser unit.

Also, the movable mirror apparatus may include a horizontal mirror upon which the RGB laser beam, as reflected by the folding mirror, impinges, and the horizontal mirror may reflect the RGB laser beam toward a vertical mirror that reflects the RGB laser beam out an exit window in the optical package.

The horizontal mirror may be driven at resonance and the vertical mirror may be driven linearly. The vertical mirror may be arranged such that the RGB laser beam exits the exit window at a desired keystone angle.

A photodiode may receive the low power feedback beam.

The beam combiner may include a single beam splitter unit arranged such that the laser light emitted by the one or more laser diodes enters into outputs of the beam splitter, such that the low power feedback beam exits from another output of the beam splitter, and such that the single laser beam exists from the input of the beam splitter.

The beam combiner may instead include first, second, and third discrete dichroic beam combiners spaced apart from one another.

Also disclosed herein is an augmented reality package, including a printed circuit board containing laser driver circuitry and mirror driver circuitry, and a compact optical package mechanically connected to the printed circuit board and electrically connected to the laser driver circuitry and mirror driver circuitry. The compact optical package includes an RGB laser unit containing red, green, and blue laser diodes within a single package, the RGB laser unit being electrically connected to the laser driver circuitry. The compact optical package also includes three lenses adjacent the RGB laser unit and configured to collimate red, green, and blue laser light emitted by the red, green, and blue laser diodes of the RGB laser unit. A beam combiner within the compact optical package is configured to combine the red, green, and blue laser light into a single RGB laser beam and to also output a lower power feedback beam. A movable mirror apparatus within the compact optical package is electrically connected to the mirror driver circuitry, and there is a fixed folding mirror upon which the single RGB laser beam output by the beam splitter impinges and which is configured to reflect the single RGB laser beam toward the movable mirror apparatus. The movable mirror apparatus is configured to, under control of the mirror driver circuitry, direct the single RGB laser beam through an exit window and to scan the single RGB laser beam in a scan pattern to form at least one desired image on a target of the augmented reality package.

The red, green, and blue laser diodes may each be formed within respective dies contained within the single package of the RGB laser unit. The respective die into which the red, green, and blue laser diodes are formed may be separated from one another by free space within the RGB laser unit.

The movable mirror apparatus may include a horizontal mirror upon which the RGB laser beam, as reflected by the folding mirror, impinges. The horizontal mirror may reflect the RGB laser beam toward a vertical mirror that reflects the RGB laser beam out an exit window in the compact optical package toward the target.

The horizontal mirror may be driven at resonance and the vertical mirror may be driven linearly. The vertical mirror may be arranged such that the RGB laser beam exits the exit window at a desired keystone angle.

A photodiode may receive the low power feedback beam.

The beam combiner may include a single beam splitter unit arranged such that the red, green, and blue laser light enters into outputs of the beam splitter, such that the low power feedback beam exits from another output of the beam splitter, and such that the single RGB laser beam exists from the input of the beam splitter.

As an alternative, the beam combiner may include first, second, and third discrete dichroic beam combiners spaced apart from one another.

Also disclosed herein is an optical package, beam equalizer optics configured to cause increase of a slow axis divergence rate of the single laser beam along a slow axis of the single laser beam such that the slow axis divergence rate is equal to a fast axis divergence rate of the single laser beam along a fast axis of the single laser beam. The movable mirror apparatus is configured to direct the single laser beam through an exit window and to scan the single laser beam in a scan pattern to form at least one desired image on a target adjacent the optical package.

The beam equalizer optics may include at least one cylindrical lens shaped such that a slow axis divergence rate of incident light is increased but a fast axis divergence rate of incident light is unaltered.

The beam equalizer optics may be positioned such that the at least one cylindrical lens increases the slow axis divergence rate of the single laser beam but does not alter the fast axis divergence rate of the single laser beam.

At least one negative spherical lens may be positioned downstream of the at least one cylindrical lens and shaped such that the slow axis divergence rate and the fast axis divergence rate of the single laser beam are increased. At least one positive spherical lens may be positioned downstream of the at least one cylindrical lens and shaped such that the slow axis divergence rate and the fast axis divergence rate of the single laser beam are stabilized as the single laser beam passes through the at least one positive spherical lens.

The at least one positive spherical lens may be shaped such that the slow axis divergence rate and the fast axis divergence rate of the single laser beam are reduced as the single laser beam passed through the at least one positive spherical lens.

The beam equalizer optics may be positioned such that the at least one cylindrical lens increases a slow axis divergence rate of the laser light from the one or more laser diodes to thereby increase the slow axis divergence rate of the single laser beam, but does not increase a fast axis divergence rate of the laser light from the one or more laser diodes such that the fast axis divergence rate of the single laser beam remains unaltered.

At least one negative spherical lens may be positioned downstream of the at least one cylindrical lens and shaped such that the slow axis divergence rate and the fast axis divergence rate of the single laser beam are increased, and at least one positive spherical lens may be positioned such that the slow axis divergence rate and the fast axis divergence rate of the single laser beam are stabilized as the single laser beam passes through the at least one positive spherical lens.

The at least one positive spherical lens may be shaped such that the slow axis divergence rate and the fast axis divergence rate of the single laser beam are reduced as the single laser beam passed through the at least one positive spherical lens.

The laser unit may contain one or more laser diodes within a single package that lases to produce laser light which exits the prism through an exit window. The at least one cylindrical lens may be positioned adjacent the exit window.

The laser unit may contain one or more laser diodes within a single package that lases to produce laser light which exits the prism through an exit window. The at least one cylindrical lens may be incorporated within the exit window.

The laser unit may contain one or more laser diodes within a single package that lases to produce laser light which exits the prism through an exit window. The exit window may be shaped such that the exit window functions as the at least one cylindrical lens.

The laser unit may contain red, green, and blue laser diodes within a single package that lases to generate red, green, and blue laser light that is initially shone through a prism within the laser unit and which exits the prism. The prism may be shaped such that the prism functions as the at least one cylindrical lens.

The laser unit may contain red, green, and blue laser diodes within a single package that lases to generate red, green, and blue laser light that is initially shone through prisms within the laser unit and which exits the prism; wherein the prisms are shaped such that the prisms function as the at least one cylindrical lens.

The movable mirror apparatus may include a horizontal mirror upon which the single laser beam, as reflected by the folding mirror, impinges, wherein the horizontal mirror reflects the single laser beam toward a vertical mirror that reflects the single laser beam out an exit window in the optical package.

The horizontal mirror may be driven at resonance and the vertical mirror may be driven linearly.

The vertical mirror may be arranged such that the single laser beam exits the exit window at a desired keystone angle.

The beam combiner may include first, second, and third discrete dichroic beam combiners spaced apart from one another.

For a better understanding of the embodiments, reference will now be made by way of example only to the accompanying drawings, wherein:
FIG. 1 is a diagrammatical representation of a first variant of a compact optical module disclosed herein.
FIG. 2 contains front and rear perspective views of the RGB laser package used in the compact optical modules disclosed herein.
FIG. 3 is a diagrammatical representation of a second variant of a compact optical module disclosed herein.
FIG. 4 is a perspective diagram of the compact optical module of FIG. 1.
FIG. 5 is diagrammatical representation of the vertical mirror, horizontal mirror, and folding mirror of FIG. 1 with a keystone angle of 0°.
FIG. 6 is diagrammatical representation of the vertical mirror, horizontal mirror, and folding mirror of FIG. 1 with a keystone angle of 5°.
FIG. 7 is diagrammatical representation of the vertical mirror, horizontal mirror, and folding mirror of FIG. 1 with a keystone angle of 14°.
FIG. 8 is a perspective view of the compact optical module of FIG. 1 as installed within a housing, in which the dimensions of the compact optical module are shown.
FIG. 9 is a perspective view of an augmented reality unit including the compact optical module of FIG. 1.
FIG. 10 is a perspective view of a pair of augmented reality glasses including the augmented reality unit of FIG. 9.
FIG. 11 is a diagrammatical view of a sample laser diode together with an indication of its slow and fast axes.
FIG. 12 is a diagrammatical view of beam equalizer and beam expander optics such as may be incorporated into the compact optical modules disclosed herein.
FIG. 13 is another diagrammatical view of beam expander optics such as may be incorporated into the compact optical modules disclosed herein.
FIG. 14 is a diagrammatical representation of a third variant of a compact optical module disclosed herein in which the compact optical module design corresponds to that of FIG. 3, but with beam equalizer optics added between the RGB laser package and the alignment lenses and beam expander added in the path of the combined RGB laser beam.
FIG. 15 is a diagrammatical representation of a fourth variant of a compact optical module disclosed herein in which the compact optical module design corresponds to that of FIG. 3, but with the beam equalizer optics incorporated in the exit window of the RGB laser package (laser unit window) and beam expander optics added in the path of the combined RGB laser beam.
FIG. 16 is a diagrammatical representation of a fifth variant of a compact optical module disclosed herein in which the compact optical module design corresponds to that of FIG. 3, but with beam equalizer optics being located between the paths of the individual R, G, and B laser beams and the path of the combined RGB laser beam.
FIG. 17 is a diagrammatical representation of a first possible configuration for the beam equalizer optics of FIG.16 as incorporated into the prism within the RGB package.
FIG. 18 is a diagrammatical cross sectional view of the prisms of FIG. 17 in which the cross section along the fast axis and slow axis of the prisms can be seen.
FIG. 19 is a diagrammatical representation of a second possible configuration for the beam equalizer optics of FIG.16 as incorporated into multiple prisms within the RGB package.
FIG. 20 illustrates results achieved using the compact optical modules described herein using the embodiments of FIGS. 14-16.

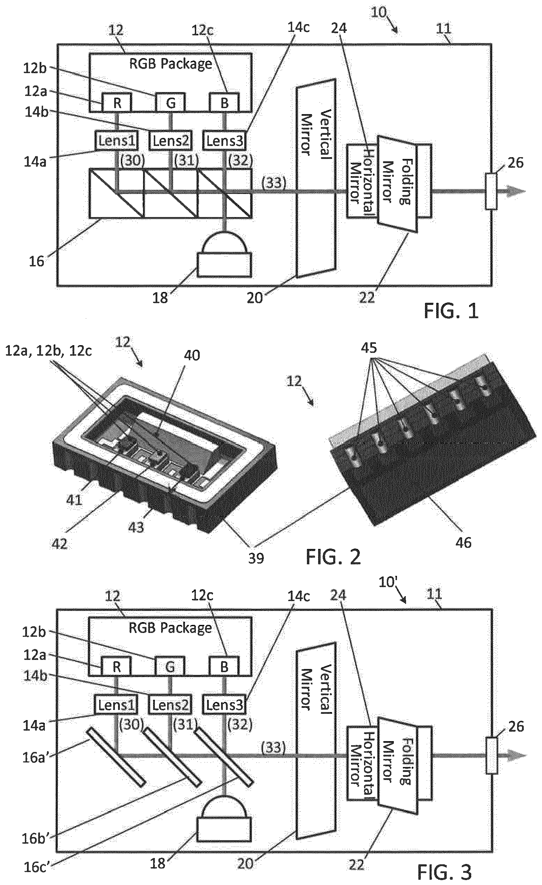

A compact optical module 10 is now described with reference to FIG. 1. The compact optical module 10 includes a housing 11 carrying a compact RGB laser package 12 that includes a red laser diode 12a, a green laser diode 12b, and a blue laser diode 12c therein.

Details of the compact RGB laser package 12 are shown in FIG. 2. The compact RGB laser package 12 includes a body 39, e.g., of aluminum nitride, on a front face of which are aluminum nitride sub-mounts 41, 42, and 43. The red laser diode 12a is mounted to the first aluminum nitride sub-mount 41, green laser diode 12b is mounted to the second aluminum nitride sub-mount 42, and the blue laser diode 12c is mounted to the third aluminum nitride sub-mount 43. The laser diodes 12a, 12b, and 12c themselves are each formed in their own die. A single glass prism 40 is mounted to the front side of the body 39, and serves to help focus the red, green, and blue laser beams respectively emitted by the red laser diode 12a, green laser diode 12b, and blue laser diode 12c, although it should be appreciated that in some instances, the element 40 may instead be three glass prisms, one for each laser diode 12a, 12b, and 13c.

On the back face of the body 39, electrical pads 45 are mounted, which provide connections to the red laser diode 12a, green laser diode 12b, and blue laser diode 12c.

A thermal pad 46 is mounted on the back face of the body 39 and makes contact with the housing 11 at the location therein where the compact RGB laser package 12 is carried. The physical dimensions of the housing 11 may be, for example, 5.3mm in width, 4mm in depth, and 1.25mm in height. Prior art systems utilize individually packaged laser diodes, each of which is nearly the size of the RGB laser package 12 used herein; thus the RGB laser package 12 provides a large amount of savings in terms of space and weight. Naturally, the RGB laser package 12 and housing 11 may have other dimensions, and the given dimensions are just examples.

Returning to FIG. 1, alignment lenses 14a, 14b, and 14c are carried within the housing 11 adjacent the RGB laser package 12, and serve to collimate the laser beams 30, 31, and 32 respectively generated by the red laser diode 12a, green laser diode 12b, and blue laser diode 12c in operation.

The alignment lenses 14a, 14b, and 14c are set such that the laser spots would overlap at a certain distance, for example, at a 450mm focal distance. In addition, the maximum angular deviation between any two laser spots should helpfully be no more than 0.2°, and the maximum deviation between all laser spots should helpfully be no more than 0.5°. The spot size produced by the red laser diode 12a, after focusing by the alignment lens 14a, is to be around 830x650 microns; the spot size produced by the blue laser diode 12b, after focusing by the alignment lens 14b, is to be around 800x600 microns; and the spot size produced by the green laser diode 12c, after focusing by the alignment lens 14c, is to be around 780x550 microns.

If the focal distance is changed from this example for a particular application, the spot size changes accordingly. The alignment lenses 14a, 14b, and 14c may have a numerical aperture of 0.38, with an effective focal length of 2mm, and a 1mm diameter, and may be coated with anti-reflective coating that allows light in the range of 400nm-700nm to pass but rejects other light. The alignment lenses 14a, 14b, and 14c may have a generally cylindrical cross section, with a flat rear surface and a convex front surface, or, in some cases, may have an aspherical shape. The effective focal length and diameter of the alignment lenses 14a, 14b, and 14c can be altered as desired for specific applications. For example, the alignment lenses 14a, 14b, and 14c may be 1.5mm in diameter. Also appreciate that in some cases, the alignment lenses 14a, 14b, and 14c may have different diameters from one another, or one of the alignment lenses may have a different diameter than the other two alignment lenses.

A beam splitter 16, and specifically a 4:1 beam splitter, is carried within the housing 11 adjacent the alignment lenses 14a, 14b, and 14c. This beam splitter 16 is a single rectangularly shaped unit formed of three square units, each square unit being comprised of two triangular prisms having their bases affixed to one another. The overall dimensions of the beam splitter may be, for example, 6mm in length, 2mm in depth, and 2.5mm in height. Naturally, these dimensions are just examples, and the beam splitter 16 may be instead of other dimensions.

The prisms of the beam splitter 16 that serve to reflect the laser beams 30 and 31 are arranged so as to reflect as close to 100% of those beams as possible along a trajectory out a side of the beam splitter 36 to help form the combined RGB laser beam 33, while the prism of the beam splitter 16 that serves to reflect the laser beam 32 is arranged so as to reflect, e.g., about 98% of the laser beam 32 out the side of the beam splitter 36 to form the combined RGB laser beam 33, while passing the remaining (here, about 2%) of the laser beam 32 through.

The remaining of the laser beam 32 may here reach a photodiode 18 used to provide feedback for the system driving the laser diodes 12a, 12b, and 12c of the RGB laser package 12.

Note that while the beam splitter 16 here is used to combine the laser beams 30, 31, and 32 to form the RGB laser beam 33, the beam splitter 16 is still technically a beam splitter, as, if a beam 33 were to be input into the side (the output) of the beam splitter 16, the beam splitter would split it to produce the beams 32 (exiting toward the lens 14c and toward the photodiode 18), 31, and 30. Thus, despite its use as a beam combiner, the component 16 is indeed a beam splitter 16.

A vertical mirror 20, horizontal mirror 24, and folding mirror 22 are adjacent the beam splitter 16, and collectively are used to reflect the RGB laser beam 33 out an exit window 26 on a housing 11 and onto a display surface.

Note that the position of the folding mirror 22 is fixed during operation, while the horizontal mirror 24 is driven to oscillate at its resonance frequency and the vertical mirror 20 is driven linearly. Therefore, the purpose of the folding mirror 22 is simply to "fold" the path of the RGB laser beam 33 to strike the horizontal mirror 24, while the purpose of the horizontal mirror 24 and vertical mirror 20 is to scan the RGB laser beam 33 across the display surface in a scan pattern designed to reproduce the desired still or moving images.

The overall dimensions of the vertical mirror 20 may be, for example, 7.94mm in length, 2.34mm in depth, and 0.67mm in height; the overall dimensions of the horizontal mirror 24 may be, for example, 4.44mm in length, 2.94mm in depth, and 0.67mm in height. Naturally, the vertical mirror 22 and horizontal mirror 24 may have other dimensions, and the given dimensions are just examples.

Note that, instead of the beam splitter 16, as shown in FIG. 3, three separate dichroic beam combiners 16a', 16b', and 16c' may be used to reproduce the RGB laser beam 33 and its illustrated path. Understand that, as compared to the beam splitter 16 which is a single component formed from sub-components bonded together, the dichroic beam combiners 16a', 16b', and 16c' are separate, discrete components. The overall dimension of each dichroic beam combiner 16a', 16b', and 16c' may be 2.6mm in length, 0.5mm in depth, and 3.2mm in height, for example. Naturally, dichroic beam combiners 16a', 16b', and 16c' may have other dimensions, and the given dimensions are just examples. The dichroic beam combiners 16a', 16b', and 16c' have the same functional operation as the beam splitter 16 described above.

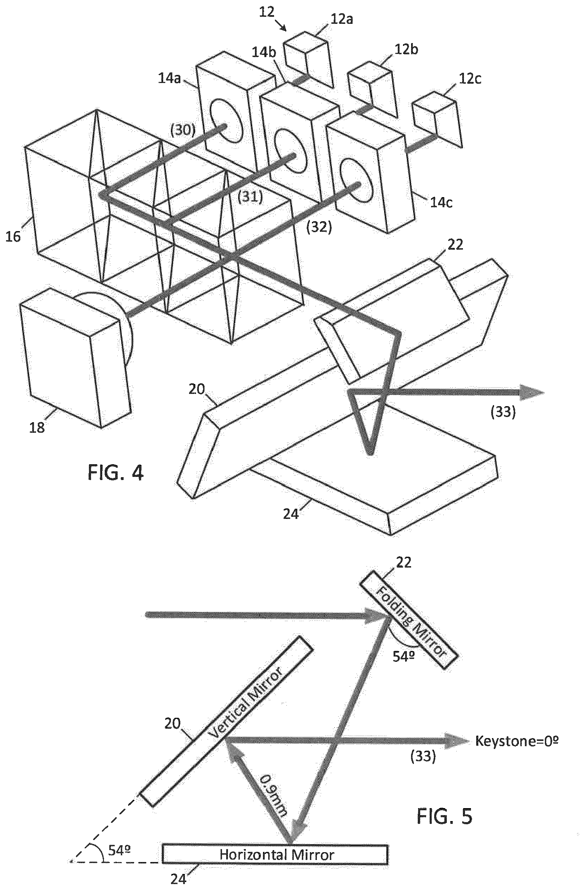

Turning now to FIG. 4, the geometry of the vertical mirror 20, horizontal mirror 24, and folding mirror 22 is now described. The RGB laser beam 33 is aimed by the beam splitter 16 to pass over the top of the vertical mirror 20 to strike the folding mirror 22, which reflects the RGB laser beam 33 onto the horizontal mirror 24, which then reflects the RGB laser beam 33 onto the vertical mirror 20, which reflects the RGB laser beam 33 out the exit window 26 on the housing 11 and onto the display surface.

Sample angles for this path taken by the RGB laser beam 33 may be seen in FIG. 5, where the folding mirror 22 reflects the RGB laser beam 33 at an angle of 54° toward the horizontal mirror 24, and the horizontal mirror 24 reflects the RGB laser beam 33 at an angle of 54° toward the vertical mirror. The vertical mirror 20 is arranged to reflect the RGB laser beam 33 in a direction parallel to the plane in which the horizontal mirror 24 lies, and therefore directly out the exit window 26 without any keystone. In this arrangement, it may be observed that the path traveled by the RGB laser beam 33 between the centers of the horizontal mirror 24 and vertical mirror 20 is about 0.9mm. The mechanical opening angle of the vertical mirror 20 is ±5°, and the mechanical opening angle of the horizontal mirror 24 is ±12°.

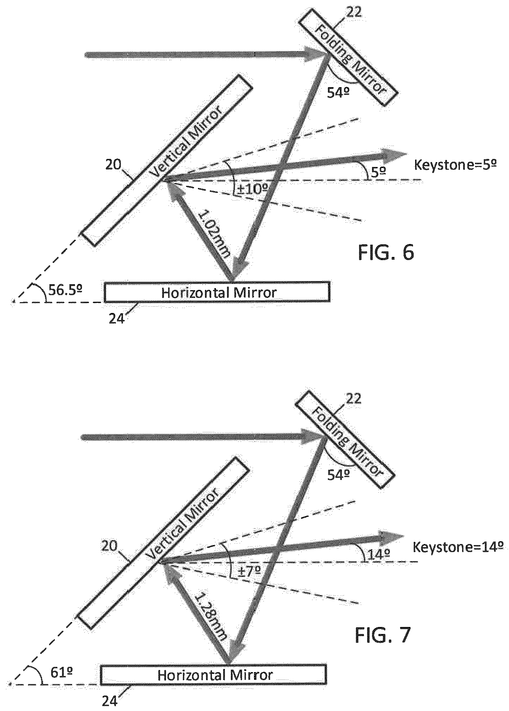

In some instances, it may be desired for the RGB laser beam 33 to exit the exit window with keystone. For example, in FIG. 6, the folding mirror 22 reflects the RGB laser beam 33 at an angle of 54° toward the horizontal mirror 24, and the horizontal mirror 24 reflects the RGB laser beam 33 at an angle of 56.5° toward the vertical mirror, and the vertical mirror 20 reflects the RGB laser beam 33 out the exit window 26 at a keystone angle of 5°, which permits ±10° in mechanical opening angle of the vertical mirror 20. In this arrangement, it may be observed that the path traveled by the RGB laser beam 33 between the centers of the horizontal mirror 24 and vertical mirror 20 is about 1.02mm.

As another example, in FIG. 7, the folding mirror 22 reflects the RGB laser beam 33 at an angle of 54° toward the horizontal mirror 24, and the horizontal mirror 24 reflects the RGB laser beam 33 at an angle of 61° toward the vertical mirror, and the vertical mirror 20 reflects the RGB laser beam 33 out the exit window 26 at a keystone angle of 14°, which permits ±7° in mechanical opening angle of the vertical mirror 20. In this arrangement, it may be observed that the path traveled by the RGB laser beam 33 between the horizontal mirror 24 and vertical mirror 20 is about 1.28mm.

From the above, it is to be noticed that the distance between the centers of the horizontal mirror 24 and vertical mirror 20 changes as the keystone angle changes. The larger the keystone, the larger the distance between the centers of the horizontal mirror 24 and vertical mirror 20, and vice versa.

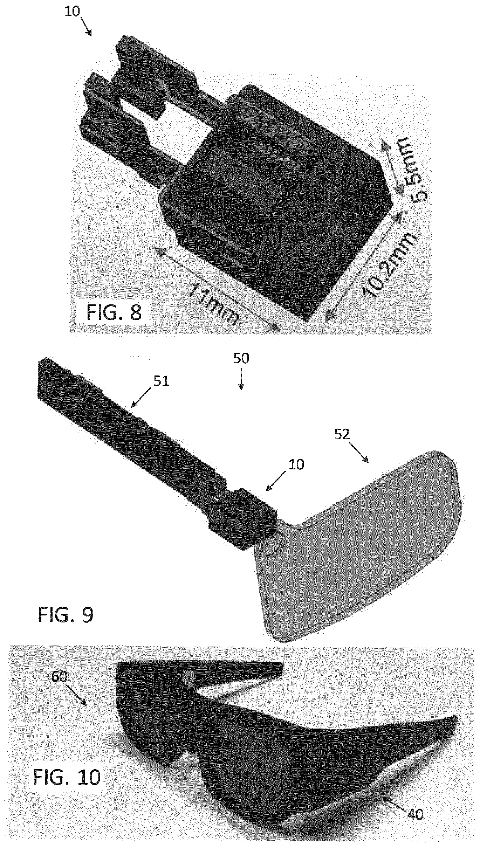

A perspective view of the compact optical module 10 may be seen in FIG. 8, where it can be seen that the housing 11 has dimensions of 10.2mm in width, 11mm in depth, and 5.5mm in height.

A potential augmented reality unit 40 is shown in FIG. 9, where it can be observed that the compact optical module 10 is installed and electrically connected to the end of a printed circuit board 51 that includes drivers for the mirrors and RGB laser package within the compact optical module 10. A target surface 52 is adjacent a laser unit window (not shown) of the compact optical module 10, and therefore in operation, images are formed on the target surface 52 by the compact optical module 10.

This augmented reality unit 40 may be installed into a pair of augmented reality glasses 60, as shown in FIG. 10, where it can be observed that the compact optical module 10 is sufficiently small such that the augmented reality glasses 60 appear to be a normal pair of eyeglasses.

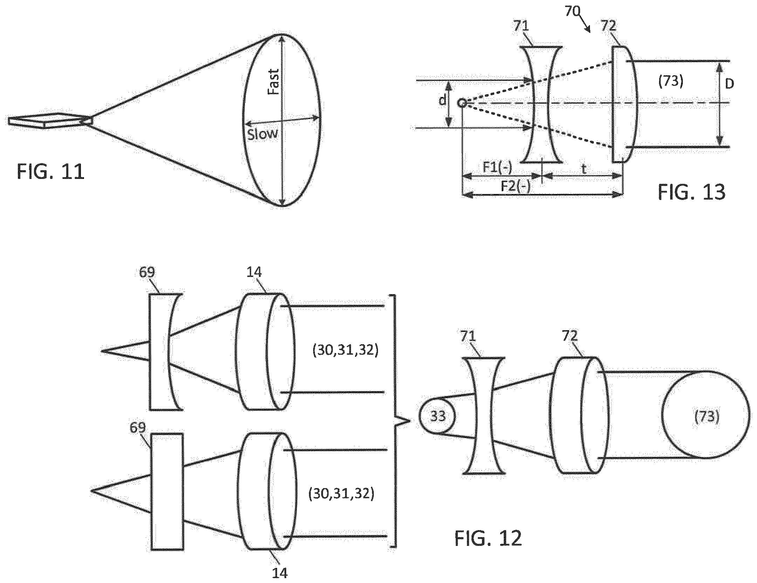

Those skilled in the art will appreciate that laser beams as generated by a laser diode typically have a slow axis and a fast axis, as shown in FIG. 11. The fast axis is called the fast axis because the beam divergence is larger along the fast axis than the slow axis. Thus, as one moves away from the laser beam source, the fast axis diameter grows at a faster rate than the diameter along the slow axis, and so it can be said that the laser beam diverges faster along its fast axis. The slow axis still diverges, however, the angle of divergence is smaller. So as to keep the beam spot produced as the laser beam strikes a target from becoming overly elongate, fast axis compressor lenses are typically used to reduce the divergence along the fast axis so that it matches the divergence along the slow axis. This is an effective solution.

However, in some applications (such as in augmented reality glasses or virtual reality headsets), certain desires come into play, such as the desire to improve color separation and remove dark areas to thereby improve overall image quality. To accomplish this, as will be described hereinbelow, instead of compressing the fast axis of the laser beam, the slow axis is expanded so that its divergence is increased to match the divergence of the fast axis, thereby creating a larger beam spot that remains generally circular.

One way that has been found to accomplish this is to insert beam equalizer optics 69 after generation of the individual R, G, and B lasers prior to their combination to form the combined RGB laser 33, as shown in FIG. 12. A beam equalizer optic (e.g., a cylindrical lens 69, or other suitable lens shaped to achieve the slow axis divergence increase described below) is placed to receive the individual R, G, and B laser beams , and has a cross section specifically designed to expand the divergence along the slow axis (but to not expand or contract the divergence along the fast axis), such that divergence along the slow axis matches the divergence along the fast axis.

In FIG. 12, the top path illustrated shows the slow axis, where the expanded divergence can be observed - for example, the divergence before the beam equalizer optic 69 may be 7°, but expanded to 22° by the beam equalizer optic 69; the bottom path illustrated shows the fast axis, where it can be observed that the divergence remains unaffected by the beam equalizer optic 69 and remains at 22°. Keep in mind that the top path in FIG. 12 represents a cross sectional view of the beam equalizer optic 69 along the slow axis while the bottom path represents a cross sectional view of the very same beam equalizer optic 69 along the fast axis.

Beam expander optics 70 that expand the combined RGB laser beam 33 in a dual axis fashion may be located downstream of the aspherical lens 14 and dichroic beam combiners 16a', 16b', and 16c', with the beam expander optics 70 including a negative spherical lens 71 that expands the slow axis and fast axis of the beam 33 equally, and a positive spherical lens 72 that stops divergence and produces an enlarged, generally circular beam 73 having a desired diameter.

Examples of the beam expander optics 70 may be seen FIG. 13, where the negative spherical lens 71 receives an incident beam having a diameter of d as it impinges upon the negative spherical lens 71, expands the divergence along both the fast and slow axis to produce a generally circular beam having a diameter of D as it impinges upon the positive spherical lens 72, and where the positive spherical lens 72 produces a stabilized combined RGB laser beam 73 having the diameter of D and remaining generally collimated.

By changing the distance t between the negative spherical lens 71 and the positive spherical lens 72, and/or by changing the focal length F2 of the positive spherical lens 72, the diameter D of the stabilized combined RGB laser beam 73 can be changed.

As a first example, the diameter d of the combined RGB laser beam 33 as it impinges upon the negative spherical lens 71 may be 0.45mm, and the diameter D of the stabilized combined RGB laser beam 73 may be 0.9mm. As a second example, the diameter d of the combined RGB laser beam 33 as it impinges upon the negative spherical lens 71 may be 0.45mm, and the diameter D of the stabilized combined RGB laser beam 73 may be 2.5mm.

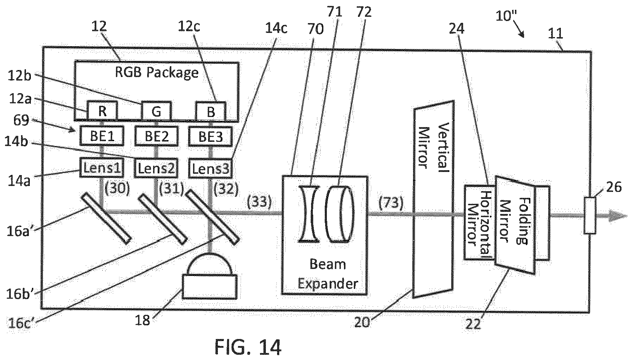

A compact optical module 10" is shown in FIG. 14. This design is the same as the design of the compact optical module 10' of FIG. 3, except beam equalizer optics 69 are inserted between the RGB laser package 12 and the lenses 14a, 14b, and 14c, and except beam expander optics 70 are inserted along the path of the combined RGB laser beam 33 between the mirror 16c' and the folding mirror 22 such that the folding mirror 22, horizontal mirror 24, and vertical mirror 20 receive the stabilized combined RGB laser beam 73 and direct it out the exit window 26.

Here, the negative spherical lens 71 is the upstream lens and the positive spherical lens 72 is the downstream lens.

In the alternative (not shown), the beam equalizer optics 69 may be incorporated within the laser unit window (not shown) of the RGB laser package 12', or the laser unit window may be shaped so as to perform this functionality.

Appreciate that instead of the compact optical module 10" matching the design of the compact optical module 10' of FIG. 3, but with the addition of the beam equalizer optics 69 and beam expander optics 70, the compact optical module 10" could instead match the design of the compact module 10 but with the addition of the beam equalizer optics 69 and beam expander optics 70.

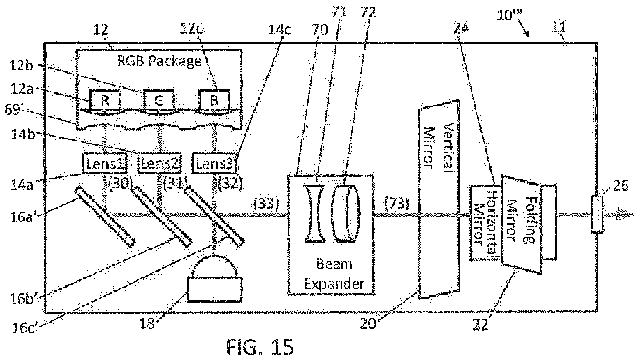

The compact optical module 10'" shown in FIG. 15 places the beam equalizer optics 69' between the laser unit window of the RGB laser package 12 and the lenses 14a, 14b, 14c.

In the alternative, beam equalizer optics 69' forms the laser unit window of the RGB laser package 12.

Thus, in the compact optical module 10" and 10"', the slow axis divergence is increased for the individual laser beams 30, 31, and 32.

Appreciate that instead of the compact optical module 10'" matching the design of the compact optical module 10' of FIG. 3, but with the addition of the beam equalizer optics 69 and beam expander optics 70, the compact optical module 10'" could instead match the design of the compact module 10 but with the additional of the beam equalizer optics 69 and beam expander optics 70.

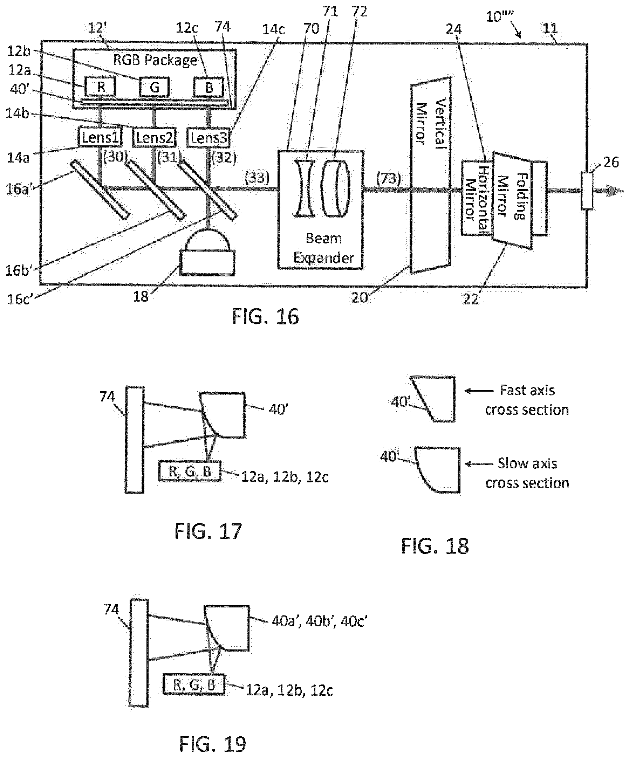

In another example of compact optical module 10"", shown in FIG. 16, the prism 40' within the RGB laser package 12' (also shown in perspective view in FIG. 2) may have its cross section shaped so as to generate the desired amount of extra slow axis divergence such that the slow axis divergence and fast axis divergence match. This example proves to be space saving, since the cylindrical 69 is eliminated, and its function is instead performed by the prism 40' which was already present. A cross section of the prism 40' within the RGB laser package 12' during operation when increasing slow axis divergence may be seen in FIG. 17. The cross section of the prism 40' is different along the fast axis than along the slow axis, as shown in FIG. 18, so that the fast axis divergence remains unchanged by the prism 40'.

In the compact optical module 10"", instead of the RGB laser package 12' containing a single prism utilized by the laser diodes 12a, 12b, and 12c, three separate prisms 40a', 40b', and 40c' may instead be utilized. Such an example is shown in FIG. 19.

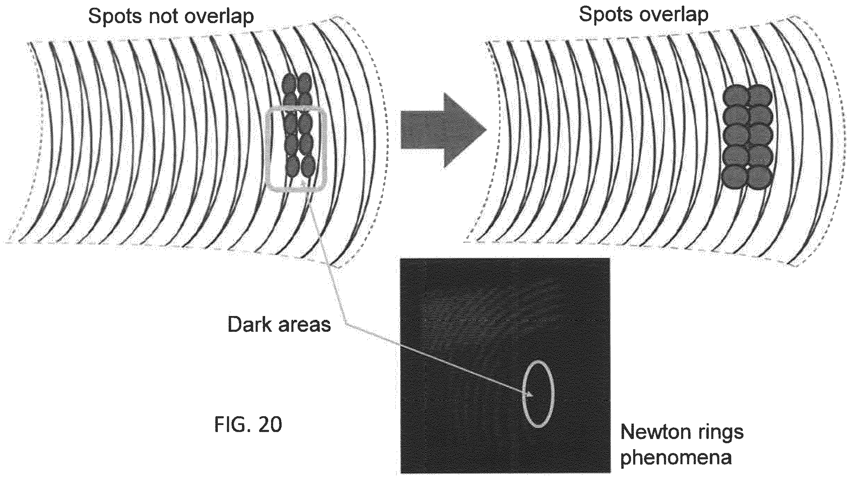

The improvements provided by this design may be observed in FIG. 20, where the beam spots formed in a scan pattern during operation of the compact optical module overlap. This eliminates the dark areas (Newton rings) that could occur is the beam spots did not overlap.

While the disclosure has been described with respect to a limited number of embodiments, those skilled in the art, having benefit of this disclosure, will appreciate that other embodiments can be envisioned that do not depart from the scope of the invention as defined by the attached claims.

## Claims

1. An optical package (10; 10'; 10"; 10"'; 10""), comprising:
a laser unit (12) containing one or more laser diodes (12a, 12b, 12c) within a single package;
a beam combiner (16; 16a', 16b, 16c') configured to combine laser light from the one or more laser diodes into a single laser beam (33; 33');
a movable mirror apparatus (20, 24); and
a fixed folding mirror (22) upon which the single laser beam output by the beam combiner impinges and which is configured to reflect the single laser beam toward the movable mirror apparatus;
wherein the movable mirror apparatus (20, 24) is configured to direct the single laser beam through an exit window (26) and to scan the single laser beam in a scan pattern to form at least one desired image on a target adjacent the optical package.

2. The optical package of claim 1, wherein the movable mirror apparatus (20, 24) includes a horizontal mirror (24) and a vertical mirror (20), the horizontal mirror being arranged on the path of the reflected single laser beam to generate a horizontally reflected laser beam, and the vertical mirror being arranged on the path of the horizontally reflected laser beam.

3. The optical package of claim 2, wherein the horizontal mirror (24) is driven at resonance and the vertical mirror (20) is driven linearly.

4. The optical package of any of the preceding claims, wherein the beam combiner comprises a single beam splitter unit (16) arranged such that the laser light emitted by the one or more laser diodes (12a, 12b, 12c) enters into outputs of the beam splitter, and such that the single laser beam exists from the input of the beam splitter.

5. The optical package of any of claims 1-3, wherein the beam combiner comprises first, second, and third discrete dichroic beam combiners (16a', 16b, 16c') spaced apart from one another.

6. The optical package of any of the preceding claims, wherein the beam combiner (16; 16a', 16b, 16c') is configured to generate a low power feedback beam exiting from another output of the beam combiner, the optical package (10; 10'; 10"; 10"'; 10"") further comprising a photodiode (18) receiving the low power feedback beam.

7. The optical package of any of the preceding claims, further comprising beam equalizer optics (69; 69') configured to cause increase of a slow axis divergence rate of the single laser beam along a slow axis of the single laser beam such that the slow axis divergence rate is equal to a fast axis divergence rate of the single laser beam along a fast axis of the single laser beam.

8. The optical package of claim 7, wherein the beam equalizer optics (69; 69') include at least one cylindrical lens shaped such that a slow axis divergence rate of incident light is increased but a fast axis divergence rate of incident light is unaltered.

9. The optical package of claim 8, wherein the single package lases to produce laser light which exits the single package through a laser unit window; and wherein the at least one cylindrical lens (69) is incorporated within the laser unit window.

10. The optical package of claim 9, wherein the laser unit window is shaped so as to function as the at least one cylindrical lens (69).

11. The optical package of claim 8, wherein the laser unit (12; 12') contains red, green, and blue laser diodes (12a, 12b, 12c) within the single package that lases to generate red, green, and blue laser light that is initially shone through at least one prism (40) within the laser unit (12; 12') and which exits the least one prism (40); wherein the least one prism is shaped such that the least one prism functions as the at least one cylindrical lens (69).

12. The optical package of any of claims 8-11, further comprising a beam expander optics (70) arranged downstream of the beam equalizer optics (69; 69').

13. The optical package of claim 12, wherein the beam expander optics ((70)) comprises at least one negative spherical lens (71) positioned downstream of the at least one cylindrical lens and shaped such that the slow axis divergence rate and the fast axis divergence rate of the single laser beam are increased, and further comprising at least one positive spherical lens (72) positioned downstream of the at least one negative spherical lens (71) and shaped such that the slow axis divergence rate and the fast axis divergence rate of the single laser beam are stabilized as the single laser beam passes through the at least one positive spherical lens.

14. The optical package of any of claims 2-13, when depending upon claim 2, wherein the vertical mirror (20) is arranged such that the single laser beam exits the exit window (26) at a desired keystone angle.

15. An augmented reality package, comprising:
a printed circuit board containing laser driver circuitry and mirror driver circuitry; and
the optical package according to any of claims 1-14, mechanically connected to the printed circuit board and electrically connected to the laser driver circuitry and mirror driver circuitry.
